# EUROPEAN PATENT APPLICATION

(11) **EP 4 827 248 A1**
(43) Date of publication of application: **21.10.2026**
(21) Application number: 24904449.6
(22) Date of filing: 13.12.2024
(51) Int. Cl.: H05K 1/02, H05K 3/28, H05K 1/14, H05K 1/18, H05K 1/11

(54) **FLEXIBLE CIRCUIT BOARD, COF MODULE, AND ELECTRONIC DEVICE COMPRISING SAME**

(30) Priority: 13.12.2023 KR 20230181132; 14.12.2023 KR 20230181921
(71) Applicant: LG Innotek Co., Ltd., Seoul 07796 (KR)
(72) Inventor: CHAE, Sung Min, Seoul 07796 (KR); PARK, Ji Hyo, Seoul 07796 (KR); JEON, Se Mi Na, Seoul 07796 (KR)
(74) Representative: DREISS Patentanwälte PartG mbB
(86) International application number: PCT/KR2024/096968
(87) International publication number: WO 2025/127885

(57) **Abstract**

A flexible circuit board according to an embodiment includes a substrate including a first surface and a second surface opposite to the first surface; a circuit pattern disposed on the first surface; and a protective layer disposed on the circuit pattern and including a plurality of open regions, wherein the substrate includes a first side end and a second side end facing each other in a first direction, wherein the open region includes a first open region provided between the first side end and the second side end, a second open region spaced from the first open region and closer to the first side end, and a third open region spaced from the first open region and closer to the second side end, wherein the circuit pattern includes: a first circuit pattern including a first pad part disposed in the first open region; a second pad part disposed in the second open region; and a first wiring part connecting between the first pad part and the second pad part; and a second circuit pattern including a third pad part disposed in the first open region; a fourth pad part disposed in the third open region; and a second wiring part connecting between the third pad part and the fourth pad part, and wherein a first direction in which the second pad part and the fourth pad part face each other, a second direction perpendicular to the first direction, and a third direction between the first direction and the second direction are defined, and wherein at least one fourth pad part extends in the third direction on the substrate.

## Description

### Technical Field

An embodiment relates to a flexible circuit board, a COF module and an electronic device including the same.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. Either pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

The flexible circuit board is bent in one direction. Accordingly, the flexible circuit board includes a bending region. Accordingly, stress occurs in the bending region. Accordingly, a circuit pattern disposed on the bending region may be peeled off.

The display panel has various sizes. Specifically, the display panel has various sizes depending on a purpose. Accordingly, a terminal of the display panel may have various sizes depending on the purpose.

Accordingly, a pad part of the flexible circuit board is formed depending on a type of the display panel. Accordingly, the flexible circuit board is combined only with a display panel for a specific purpose. Therefore, a manufacturing process becomes difficult.

Accordingly, there is a need for a flexible circuit board with a new structure capable of solving the above problems, a COF module, and an electronic device including the same.

As a patent related to the flexible circuit board, Korean Patent Registration No. KR10-0618898 (2006.09.01) is disclosed.

### Disclosure

### Technical Problem

The embodiment provides a flexible circuit board having improved reliability.

The embodiment provides a flexible circuit board connected to various display panels.

The embodiment provides a flexible circuit board and a COF module capable of measuring a performance of a display panel before connecting the flexible circuit board to the display panel.

Technical problems to be solved by the proposed embodiments are not limited to the above-mentioned technical problems, and other technical problems not mentioned may be clearly understood by those skilled in the art to which the embodiments proposed from the following descriptions belong.

### Technical Solution

A flexible circuit board according to an embodiment comprises a substrate including a first surface and a second surface opposite to the first surface; a circuit pattern disposed on the first surface; and a protective layer disposed on the circuit pattern and including a plurality of open regions, wherein the substrate includes a first side end and a second side end facing each other in a first direction, wherein the open region includes a first open region provided between the first side end and the second side end, a second open region spaced from the first open region and closer to the first side end, and a third open region spaced from the first open region and closer to the second side end, wherein the circuit pattern includes: a first circuit pattern including a first pad part disposed in the first open region; a second pad part disposed in the second open region; and a first wiring part connecting between the first pad part and the second pad part; and a second circuit pattern including a third pad part disposed in the first open region; a fourth pad part disposed in the third open region; and a second wiring part connecting between the third pad part and the fourth pad part, and wherein a first direction in which the second pad part and the fourth pad part face each other, a second direction perpendicular to the first direction, and a third direction between the first direction and the second direction are defined, and wherein at least one fourth pad part extends in the third direction on the substrate.

In addition, the fourth pad part extends in the first direction and the third direction.

In addition, the fourth pad part includes a central pad part and an outer pad part, the central pad part extends in the first direction, and the outer pad part extends in the third direction.

In addition, an inclination angle of the outer pad part increases as it moves away from the central pad part.

In addition, the second wiring part includes a second-first wiring part and a second-second wiring part, the second-first wiring part extends in the first direction, the second-second wiring part extends in the first direction and the third direction, and a maximum inclination angle of the outer pad part is smaller than a maximum inclination angle of the second-second wiring part.

In addition, the outer pad part extends in a different direction from at least one pad part among the first pad part, the second pad part, and the third pad part.

In addition, the circuit pattern further includes a third circuit pattern including a fifth pad part disposed in the second open region; a sixth pad part disposed in the third open region; and a third wiring part connecting between the fifth pad part and the sixth pad part.

In addition, at least one sixth pad part extends in the third direction.

In addition, the sixth pad part extends in the first direction and the third direction.

In addition, the sixth pad part includes a central pad part and an outer pad part, the central pad part extends in the first direction, and the outer pad part extends in the third direction.

In addition, an inclination angle of the outer pad part increases as it moves away from the central pad part.

In addition, the outer pad part extends in a different direction from at least one of the first pad part, the second pad part, the third pad part, and the fifth pad part.

In addition, the flexible circuit board further comprises a test pattern disposed on the substrate.

In addition, the test pattern includes a seventh pad part, an eighth pad part, and a fourth wiring part, and a line width of the seventh pad part is larger than a line width of the eighth pad part.

In addition, the seventh pad part is adjacent to the second wiring part, the eighth pad part is adjacent to the fourth pad part, and the fourth wiring part connects the seventh pad part and the eighth pad part.

In addition, the seventh pad part is connected to a test device, and the eighth pad part is disposed in the third open region.

In addition, the protective layer is not disposed on the seventh pad part and the eighth pad part.

In addition, the protective layer is disposed on the seventh pad part and is not disposed on the eighth pad part, the seventh pad part includes a first region where the protective layer is not disposed and a second region where the protective layer is disposed, and an area of the first region is 80% to 99% of an area of the seventh pad part.

In addition, a line width of the seventh pad part is greater than a spacing between at least one of the first pad part, the second pad part, the third pad part, and the fourth pad part.

In addition, the line width of the seventh pad part is greater than a line width of at least one of the first pad part, the second pad part, the third pad part, and the fourth pad part.

In addition, the seventh pad part includes a seventh-first pad part and a seventh-second pad part disposed on the first surface, the fourth wiring part includes a fourth-first wiring part disposed on the first surface and a fourth-second wiring part disposed on the second surface, the eighth pad part includes an eighth-first pad part and an eighth-second pad part disposed on the second surface, the eighth-first pad part is adjacent to the fourth pad part, the eighth-second pad part is adjacent to the sixth pad part, and the fourth-first wiring part and the fourth-second wiring part are connected through a via.

### Advantageous Effects

A flexible circuit board according to an embodiment includes a second circuit pattern connected to a display panel and a chip. The second circuit pattern includes a second wiring part, a third pad part, and a fourth pad part.

The second wiring part includes a second-first wiring part and a second-second wiring part. The second-first wiring part extends in a linear direction, and the second-second wiring part extends in a diagonal direction. The second-first wiring part has a length of a set range. Therefore, the second-first wiring part is mostly or all disposed on a bending region of the flexible circuit board.

Therefore, bending characteristics and reliability of the flexible circuit board are improved.

The third pad part is connected to the chip, and the fourth pad part is connected to the display panel. The third pad part and the fourth pad part extend in different directions. The fourth pad part extends in an oblique direction. The fourth pad part extends in a diagonal direction.

Therefore, the fourth pad part can be connected to a display panel having various sizes. In addition, the fourth pad part can be connected to a display panel having various terminal sizes.

Therefore, it is not necessary to use a different flexible circuit board depending on a size of the display panel. Accordingly, the flexible circuit board can be applied to display panels for various purposes.

In addition, the flexible circuit board according to the embodiment includes a test pattern.

The flexible circuit board is connected to the display panel and the circuit board. The test pattern can measure a performance of the display panel. Accordingly, the performance of the display panel can be confirmed before connecting the flexible circuit board and the display panel. Accordingly, it is possible to prevent a defect in the COF module due to a defect in the performance of the display panel after connecting the flexible circuit board, the display panel, and the circuit board.

The test pattern includes one pad part connected to the display panel and other pad part connected to the test device.

A line width of the other pad part is larger than a line width of the one pad part. The other pad part is formed by removing the protective layer. Since the line width of the other pad part is large, a process of removing the protective layer can be easily performed. Accordingly, process efficiency is improved. In addition, when removing the protective layer, it is possible to prevent other patterns from being exposed to an outside of the protective layer.

The test pattern is disposed on an outermost side of the substrate. Accordingly, interference of the test pattern can be prevented when connecting the flexible circuit board and the display panel.

Therefore, the reliability and electrical characteristics of the flexible circuit board and the COF module according to the embodiment are improved.

### Description of Drawings

FIG. 1 is a top view of a flexible circuit board according to a first embodiment.
FIG. 2 is an enlarged view of a region A of FIG. 1.
FIG. 3 and FIG. 4 are views for explaining a connection between a fourth pad part and a terminal of a display panel when a fourth pad part is a straight line.
FIG. 5 and FIG. 6 are views for explaining a connection between a fourth pad part and a terminal of a display panel when a fourth pad part is an oblique line.
FIG. 7 and FIG. 8 are cross-sectional views taken along a region A-A' of FIG. 1.
FIG. 9 is a top view of a flexible circuit board according to a second embodiment.
FIG. 10 is a bottom view of a flexible circuit board according to a second embodiment.
FIG. 11 is an enlarged view of a region B of FIG. 9.
FIG. 12 is an enlarged view of a region C of FIG. 9.
FIG. 13 is an enlarged view of a region D of FIG. 10.
FIG. 14 is a top view of a flexible circuit board according to a third embodiment.
FIG. 15 and FIG. 16 are enlarged views of a region A of FIG. 14.
FIG. 17 is a top view of a flexible circuit board according to a fourth embodiment.
FIG. 18 is a bottom view of a flexible circuit board according to a fourth embodiment.
FIG. 19 is an enlarged view of a region B of FIG. 17.
FIG. 20 is an enlarged view of a region C of FIG. 18.
FIG. 21 and FIG. 22 are views for explaining a connection of a COF module and other members according to an embodiment.
FIG. 23 to FIG. 25 are views regarding an electronic device including a flexible circuit board according to an embodiment.

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, with reference to the drawings, a flexible circuit board according to an embodiment and a COF module including the same will be described.

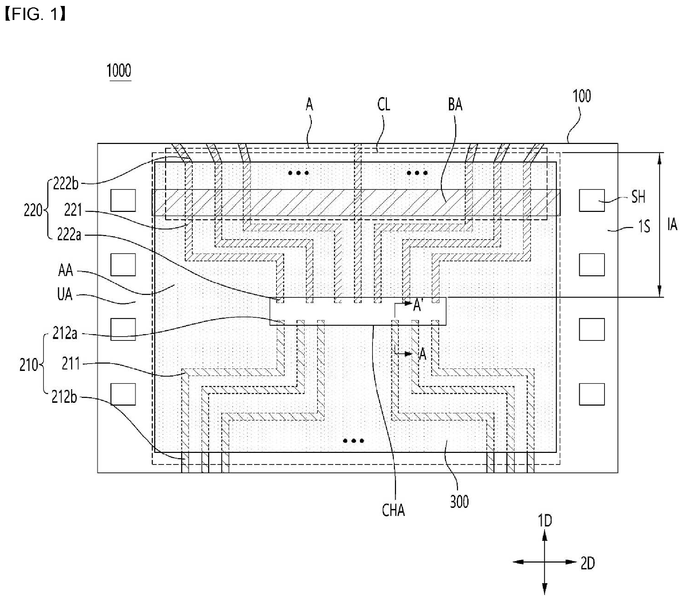

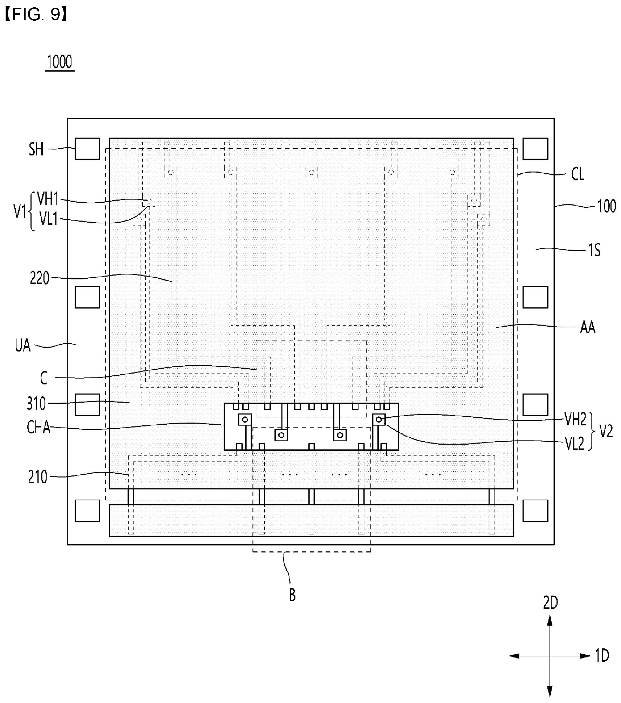

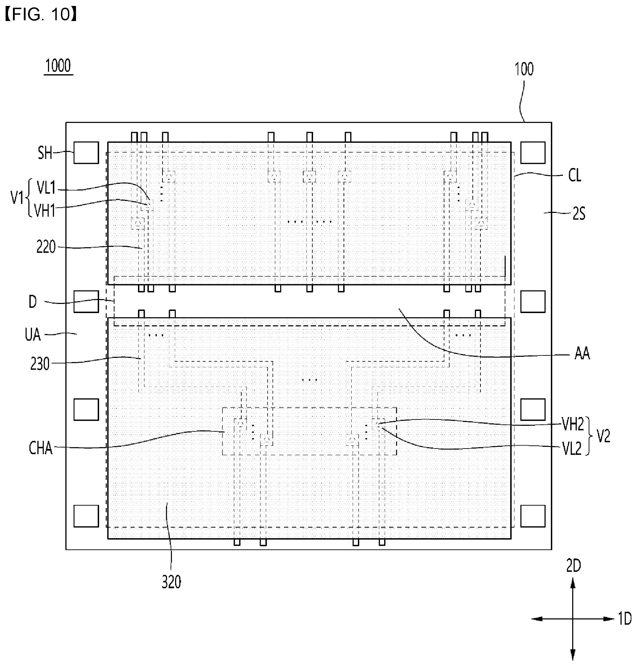

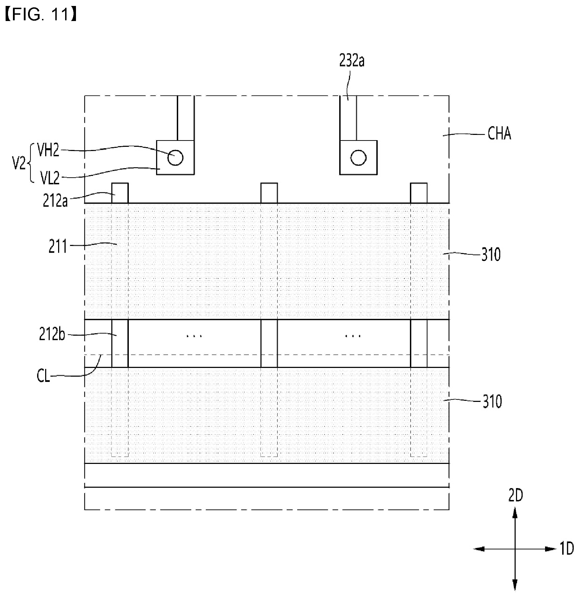

FIGS. 1 to 8 are views for describing a flexible circuit board according to a first embodiment. FIGS. 9 to 13 are views for describing a flexible circuit board according to a second embodiment.

Referring to FIGS. 1 to 8, a flexible circuit board 1000 according to the first embodiment includes a substrate 100, a circuit pattern, and a protective layer 300.

The substrate 100 includes a first surface 1S and a second surface 2S opposite to the first surface 1S. A circuit pattern and a protective layer 300 are disposed on the first surface 1S.

The substrate 100 includes a cutting line CL. The flexible circuit board 1000 is cut along the cutting line CL. For example, a circuit pattern, a metal pattern, a protective layer, and a chip are disposed on the substrate 100. Afterwards, the substrate 100 is cut along the cutting line CL. Accordingly, the COF module is manufactured. Therefore, an edge of the COF module becomes the cutting line CL.

The substrate 100 includes an effective region AA and an ineffective region UA. In detail, the first surface 1S includes an effective region AA and an ineffective region UA.

The effective region AA and the ineffective region UA are separated by the cutting line CL. The effective region AA is an inner region of the cutting line CL. In addition, the ineffective region UA is an outer region of the cutting line CL.

A circuit pattern, a protective layer, and a chip are disposed in the effective region AA. In addition, a dummy pattern and a sprocket hole SH are disposed in the ineffective region UA. The dummy pattern increases a strength of the substrate 100. In addition, the flexible circuit board 1000 is rolled or unrolled in a roll-to-roll manner by a sprocket hole SH.

The substrate 100 includes a chip mounting region CHA. The chip mounting region CHA is disposed on the first surface 1S. The chip mounting region CHA is disposed in the effective region AA. A chip CH is disposed in the chip mounting region CHA. In addition, pad parts of the circuit pattern are disposed inside the chip mounting region CHA. In addition, the protective layer 300 is not disposed in the chip mounting region CHA.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board can be applied to various electronic devices including a curved display device.

The substrate 100 can have a thickness of 20 um to 100 um. For example, the substrate 100 can have a thickness of 25 um to 50 um. For example, the substrate 100 can have a thickness of 30 um to 40 um. If the thickness of the substrate 100 exceeds 100 um, an overall thickness of the flexible circuit board increases. Accordingly, flexible characteristics of the flexible circuit board can be reduced. In addition, if the thickness of the substrate 100 is less than 20 um, the substrate 100 can be damaged by heat and pressure applied to the substrate 100 when mounting a chip on the flexible circuit board.

The circuit pattern and the protective layer 300 are disposed on the substrate 100. In detail, the circuit pattern and the protective layer 300 are disposed on the first surface 1S. In detail, the circuit pattern and the protective layer 300 are disposed in at least one of the effective region AA and the ineffective region UA.

The circuit pattern includes a first circuit pattern 210 and a second circuit pattern 220.

Referring to FIG. 1, the first circuit pattern 210 includes a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a pad part of the circuit board 3000. Accordingly, the first circuit pattern 210 and the circuit board 3000 are connected.

The first wiring part 211 is disposed between the first pad part 212a and the second pad part 212b. The first wiring part 211 connects the first pad part 212a and the second pad part 212b. Accordingly, the chip CH and the circuit board 3000 are connected. Therefore, a signal generated from the chip CH is transmitted to the circuit board 3000.

The first circuit pattern 210 may further include a test pad part. That is, the second pad part 212b can serve as a first test pad part.

Before connecting the circuit board and the second pad part 212b, the first circuit pattern 210 can be tested by the first test pad part. For example, the first test pad part can be used to check whether the first circuit pattern is open or shorted.

The second circuit pattern 220 includes a second wiring part 221, a third pad part 222a, and a fourth pad part 222b. The second wiring part 221, the third pad part 222a, and the fourth pad part 222b can include a same material. In addition, the second wiring part 221, the third pad part 222a, and the fourth pad part 222b can be formed integrally.

The third pad part 222a is disposed inside the chip mounting region CHA. Accordingly, the third pad part 222a is connected to a terminal of the chip. Accordingly, the second circuit pattern 220 and the chip CH are connected.

The fourth pad part 222b is disposed outside the chip mounting region CHA. The fourth pad part 222b is connected to a pad part of an external display panel 4000. Accordingly, the second circuit pattern 220 and the display panel 4000 are connected.

The second wiring part 221 is disposed between the third pad part 222a and the fourth pad part 222b. The second wiring part 221 connects the third pad part 222a and the fourth pad part 222b. Accordingly, the chip CH and the display panel 4000 are connected. Therefore, a signal generated from the chip CH is transmitted to the display panel 4000.

The first circuit pattern 210 may further include a test pad part. That is, the fourth pad part 212b may function as a second test pad part.

Before connecting the display panel and the fourth pad part 212b, the second circuit pattern 220 may be tested by the second test pad part. For example, the second test pad part may be used to check whether the second circuit pattern is open or shorted.

Although not shown in the drawing, the circuit pattern may further include a third circuit pattern. The third circuit pattern is not connected to the chip. The third circuit pattern is connected to the circuit board and the display panel.

The third circuit pattern may be a bypass circuit. For example, the third circuit pattern may be a power supply pattern. Accordingly, the circuit board and the display panel may be supplied with power by the third circuit pattern.

A line width and a spacing of the third circuit pattern may be larger than a line width and a spacing of the first and second circuit patterns 210 and 220.

Although not shown in the drawing, at least one dummy pattern may be disposed in the effective region AA.

The dummy pattern may prevent the flexible circuit board 1000 from being bent. In addition, a spacing and a line width of the circuit pattern may be made uniform by the dummy pattern.

The dummy pattern may include a same material as the circuit pattern. The line width of the dummy pattern may be same as or different from the circuit pattern. The dummy pattern is not connected to the chip CH, the circuit board 3000, and the display panel 4000.

The protective layer 300 is disposed on the first surface 1S. Accordingly, the protective layer 300 is disposed on the first circuit pattern 210, the second circuit pattern 220, and the third circuit pattern. The protective layer 300 is disposed on the first wiring part 211 and the second wiring part 221. The protective layer 300 is not disposed on the first pad part 212a, the second pad part 212b, the third pad part 222a, and the fourth pad part 222b. In addition, the protective layer 300 is not disposed in the chip mounting region CHA.

For example, the protective layer 300 includes a plurality of open regions. In addition, the substrate 100 includes a first side end and a second side end facing each other in a first direction.

At this time, the protective layer 300 includes a first open region corresponding to the chip mounting region CHA. In addition, the protective layer 300 includes a second open region that is spaced apart from the first open region and is disposed closer to a first side end of the substrate 100. In addition, the protective layer 300 includes a third open region that is spaced apart from the first and second open regions and is disposed closer to a second side end of the substrate 100. At this time, the first open region may be defined as a chip mounting region CHA where a chip is disposed. In addition, the second open region may be defined as a board connection region where a circuit board is connected. In addition, the third open region may be defined as a panel connection region where a display panel is connected. However, the embodiment is not limited thereto, and depending on a product design, the second open region may be defined as a panel connection region, and the third open region may be defined as a board connection region.

The flexible circuit board 1000 includes a bending region BA. The flexible circuit board 1000 is bent in one direction on the bending region BA. The flexible circuit board 1000 includes a separation region IA. The separation region IA is a region between the chip mounting region CHA and the fourth pad part 222b. The bending region BA is disposed on the separation region IA.

The second circuit pattern 220 is disposed on the separation region IA. In detail, the second wiring part 221 is disposed on the separation region IA.

The flexible circuit board 1000 includes a first direction 1D, a second direction 2D, and a third direction. The first direction 1D is a direction in which the second pad part 212b and the fourth pad part 222b face each other. The second direction 2D is a direction perpendicular to the first direction 1D. The third direction is a direction between the first direction 1D and the second direction 2D.

The second wiring part 221 extends in a plurality of directions. For example, the second wiring part 221 may include a second-first wiring part and a second-second wiring part. The second-first wiring part extends in the first direction 1D. That is, the second-first wiring part extends in a straight line. The second-second wiring part extends in the third direction. That is, the second-second wiring part extends obliquely.

Accordingly, a second wiring part 221 extending in a plurality of directions is disposed on the separation region IA. A second-first wiring part may be disposed on the bending region BA. For this purpose, the second-first wiring part may have a set length.

In detail, a length of the second-first wiring part may be 1000 um to 3000 um, 1500 um to 2800 um, or 2300 um to 2600 um. Accordingly, the second wiring part 221 can sufficiently secure a length of the second-first wiring part extending in a straight direction. Accordingly, most of the second wiring parts disposed on the bending region BA may be the second-first wiring part. Alternatively, all of the second wiring parts disposed on the bending region BA may be the second-first wiring part.

The bending region BA is bent in one direction. Accordingly, if a direction in which the flexible circuit board is bent and a direction in which the second wiring part is extended have an angle, bending characteristics of the flexible circuit board may decrease.

In addition, stress occurs on the bending region BA. The second wiring part may be stretched by the stress. When the second wiring part is disposed obliquely, the second wiring part may be peeled off as the stress extends in the first direction.

Therefore, the flexible circuit board forms a length of the second-first wiring part within a set range. Accordingly, most or all of the second wiring parts on the bending region extend in the first direction. Therefore, bending characteristics and reliability of the flexible circuit board are improved.

The fourth pad part 222b extends in a plurality of directions. The fourth pad part 222b may extend in a different direction from the second wiring part 221. The fourth pad part 222b extends in a different direction from the third pad part 222a. The fourth pad part 222b extends in a different direction from at least one of the first pad part 212a and the second pad part 212b.

The fourth pad part 222b may extend in a third direction. Alternatively, the fourth pad part 222b may extend in the first direction 1D and the third direction. That is, at least one fourth pad part may extend in the third direction.

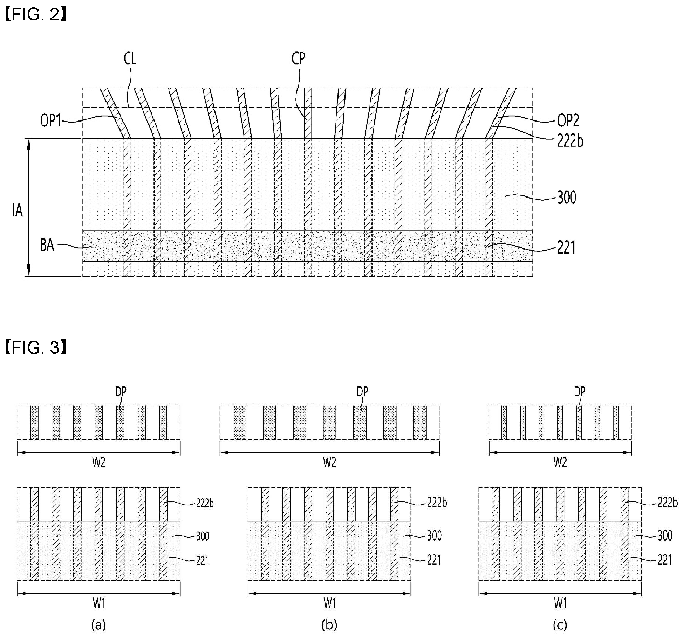

Referring to FIG. 1 and FIG. 2, the fourth pad part 222b may extend in the first direction 1D and the third direction. The fourth pad part 222b is connected to the second wiring part 221. The second wiring part 221 includes one central wiring part and an outer wiring part. The outer wiring part may be disposed on a left side and a right side of the central wiring part in the second direction 2D.

Therefore, the fourth pad part 222b may include one central pad part CP and a plurality of outer pad parts. The outer pad part may include a plurality of first outer pad parts OP1 and a plurality of e second outer pad parts OP2. The first outer pad part OP1 is disposed in a left direction of the central pad part CP. The second outer pad part OP2 is disposed in a right direction of the central pad part CP.

The central pad part CP extends in the first direction 1D. The first outer pad part OP1 and the second outer pad part OP2 extend in the third direction. The outer pad parts OP1 and OP2 may be symmetrically disposed with respect to the central pad part CP.

The first outer pad part OP1 and the second outer pad part OP2 are inclined. That is, the first outer pad part OP1 and the second outer pad part OP2 are disposed obliquely.

Inclination angles of the first outer pad parts OP1 may vary while extending in the second direction 2D. The inclination angles of the first outer pad parts OP1 may vary as the first outer pad parts OP1 move away from the central pad part CP. An inclination angle of the first outer pad part OP1 is an angle formed by the central pad part CP and the first outer pad part OP1. In detail, the inclination angles of the first outer pad parts OP1 may increase as they move away from the central pad part CP.

The inclination angles of the first outer pad parts OP1 may be different from inclination angles of the second-second wiring part. The inclination angles of the second-second wiring part are angles formed by the second-first wiring part and the second-second wiring part. In detail, maximum inclination angles of the first outer pad parts OP1 may be smaller than maximum inclination angles of the second-second wiring part.

The inclination angles of the second outer pad parts OP2 may vary as they extend in the second direction 2D. The inclination angle of the second outer pad part OP2 is an angle formed by the central pad part CP and the second outer pad part OP2. In detail, the inclination angles of the second outer pad parts OP2 may increase while extending in the second direction 2D.

The inclination angles of the second outer pad parts OP2 may be different from the inclination angles of the second-second wiring part. In detail, maximum inclination angles of the second outer pad parts OP2 may be smaller than maximum inclination angles of the second-second wiring part.

Since the first outer pad part OP1 and the second outer pad part OP2 are disposed obliquely, first outer pad part OP1 and the second outer pad part OP2 can be easily connected to terminals of various display panels.

FIGS. 3 to 6 are views for explaining a connection between a fourth pad part 222b and a terminal DP of the display panel according to an extension direction of the fourth pad part 222b.

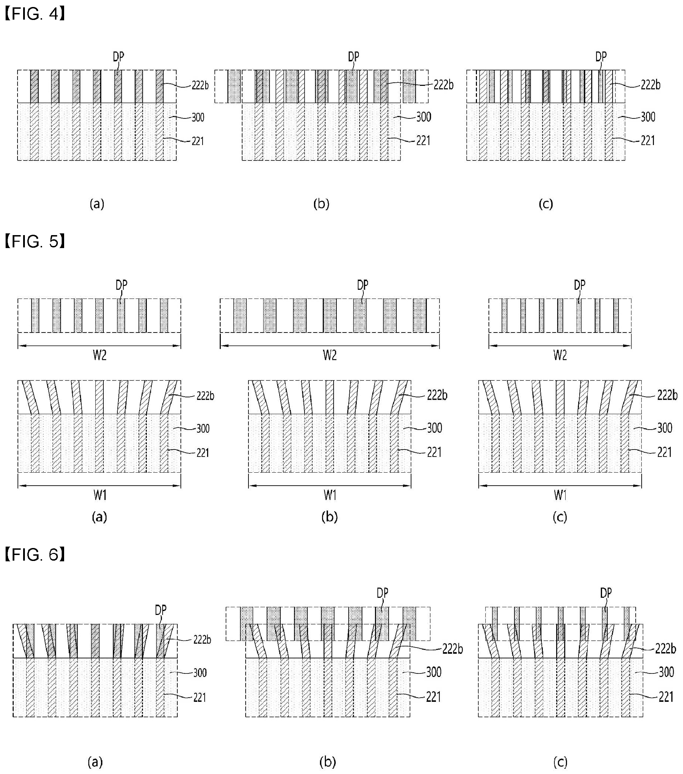

Referring to FIGS. 3 and 4, the fourth pad part 222b extends in a straight line. Referring to (a) of FIGS. 3 and 4, sizes of the flexible circuit board and the display panel may be the same or similar. In detail, a width W1 of a pad part region where the fourth pad part is disposed and a width W2 of a terminal region where a terminal is disposed may be the same or similar. In this case, both the fourth pad part 222b and the terminal DP may be connected.

Referring to (b) and (c) of FIGS. 3 and 4, sizes of the flexible circuit board and the display panel may be different. In detail, the width W1 of the pad part region and the width W2 of the terminal region may be different.

Referring to (b) of FIGS. 3 and 4, the width W1 of the pad part region may be smaller than the width W2 of the terminal region. In this case, the fourth pad part 222b and the terminal DP are not all connected. That is, some pad parts and some terminals are not connected due to a difference in line widths between the fourth pad part 222b and the terminal DP.

Referring to (c) of FIGS. 3 and 4, the width W1 of the pad part region may be larger than the width W2 of the terminal region. In this case, the fourth pad part 222b and the terminal DP are not all connected. That is, some pad parts and some terminals are not connected due to a difference in line widths of the fourth pad part 222b and the terminal DP.

The embodiment solves the above problem by controlling the extension direction of the fourth pad part 222b. In detail, the fourth pad part 222b of the embodiment extends in an oblique direction.

Referring to FIGS. 5 and 6, the fourth pad part 222b extends in an obliquely. Referring to FIGS. 5 and 6 (a), sizes of the flexible circuit board and the display panel may be the same or similar. In detail, a width W1 of the pad part region and a width W2 of the terminal region may be the same or similar. In this case, all of the fourth pad part 222b and the terminal DP may be connected to each other.

Referring to (b) and (c) of FIGS. 5 and 6, sizes of the flexible circuit board and the display panel may be different. In detail, the width W1 of the pad part region and the width W2 of the terminal region may be different.

Referring to (b) of FIGS. 5 and 6, the width W1 of the pad part region may be smaller than the width W2 of the terminal region. In this case, all of the fourth pad part 222b and the terminal DP are connected to each other. The fourth pad part 222b extends in an oblique direction. Therefore, a portion where the fourth pad part and the terminal DP intersect is also covered by the fourth pad part 222b. Therefore, even if the line width of the terminal DP is larger than the line width of the fourth pad part 222b, all of the fourth pad part 222b and the terminal DP are connected to each other.

Referring to (c) of FIG. 5 and FIG. 6, the width W1 of the pad part region may be larger than the width W2 of the terminal region. In this case, all of the fourth pad part 222b and the terminal DP are connected to each other. The fourth pad part 222b extends in an oblique direction. Therefore, a portion where the fourth pad part and the terminal DP intersect is also covered by the fourth pad part 222b. Therefore, even if the line width of the terminal DP is smaller than the line width of the fourth pad part 222b, all of the fourth pad part 222b and the terminal DP are connected to each other.

Therefore, the flexible circuit board according to the embodiment can prevent bonding defects between the flexible circuit board and the display panel even if the sizes of the fourth pad part 222b and the terminal DP of the display panel are different.

In addition, even if the width W1 of the pad part region and the width W2 of the terminal region are different from design dimensions due to a difference in shrinkage rate between the flexible circuit board and the display during a connection process between the fourth pad part 222b and the terminal DP of the display panel, the difference can be supplemented and bonding defects can be prevented.

The embodiment is not limited to facilitating connection with the display panel when the fourth pad part 222b extends obliquely. The second pad part 212b can also be formed obliquely. That is, the bonding defect with the display panel and the circuit board can be reduced by forming at least one of the second pad part 212b and the fourth pad part 222b obliquely. By forming both the second pad part 212b and the fourth pad part 222b obliquely, the bonding defect with the display panel and the circuit board can be reduced. Since a pitch of terminals of the circuit board is larger than a pitch of terminals of the display panel, the fourth pad part 222b may be formed obliquely, and the second pad part 212b may be formed in a straight line in order to reduce a total width of the flexible circuit board.

A flexible circuit board according to an embodiment includes a second circuit pattern connected to a display panel and a chip. The second circuit pattern includes a second wiring part, a third pad part, and a fourth pad part.

The second wiring part includes a second-first wiring part and a second-second wiring part. The second-first wiring part extends in a linear direction, and the second-second wiring part extends in a diagonal direction. The second-first wiring part has a length of a set range. Therefore, the second-first wiring part is mostly or all disposed on a bending region of the flexible circuit board.

Therefore, bending characteristics and reliability of the flexible circuit board are improved.

The third pad part is connected to the chip, and the fourth pad part is connected to the display panel. The third pad part and the fourth pad part extend in different directions. The fourth pad part extends in an oblique direction. The fourth pad part extends in a diagonal direction.

Therefore, the fourth pad part can be connected to a display panel having various sizes. In addition, the fourth pad part can be connected to a display panel having various terminal sizes.

Therefore, it is not necessary to use a different flexible circuit board depending on a size of the display panel. Accordingly, the flexible circuit board can be applied to display panels for various purposes.

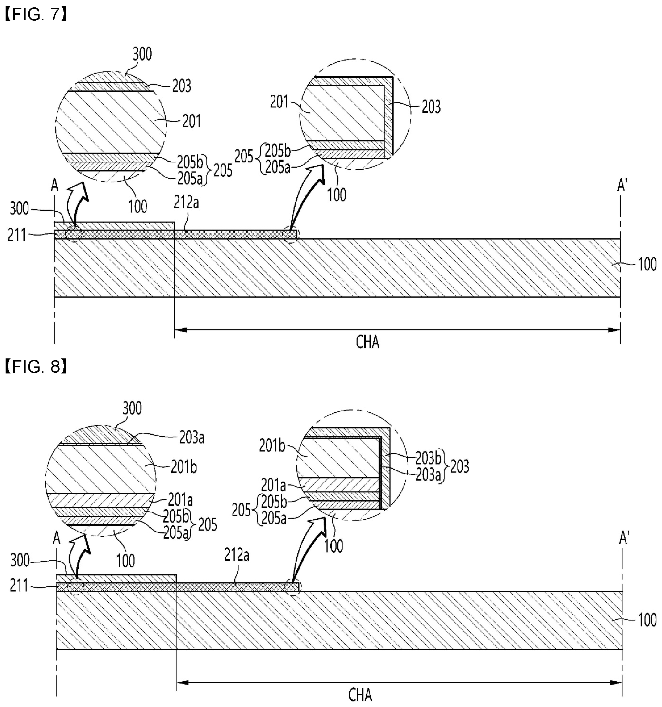

Referring to FIGS. 7 and 8, the circuit pattern is formed in a multilayer structure. FIGS. 7 and 8 are shown based on the first circuit pattern. The following description applies equally to the second and third circuit patterns.

Referring to FIG. 7, the first circuit pattern is formed in multilayers. In detail, the first wiring part 211, the first pad part 212a, and the second pad part 212b include a buffer layer 205, a metal layer 201, and a bonding layer 203.

The buffer layer 205 may include multilayers. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the circuit pattern. For example, the second buffer layer 205b may include chromium (Cr).

The buffer layer 205 may have a thin film thickness in nanometer units. For example, the buffer layer 205 may have a thickness of 20 nm or less.

An adhesion between the substrate 100 and the circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using a buffer layer as a seed layer. That is, the metal layer 201 may be a plating layer.

A thickness of the metal layer 201 may be 5 um to 30 um.

The bonding layer 203 is disposed on the metal layer 201.

The bonding layer 203 is disposed on a side surface and an upper surface of the metal layer 201. For example, the bonding layer 203 may be disposed while surrounding the metal layer 201.

The bonding layer 203 includes a metal. For example, the bonding layer 203 may include tin (Sn). The bonding layer 203 is formed by a plating process. In detail, the bonding layer 203 may be a plating layer.

A thickness of the bonding layer 203 may be 0.3 um to 0.7 um. A tin content of the bonding layer 203 may increase as it extends from a lower surface of the bonding layer 203 toward the upper surface of the bonding layer 203.

That is, the bonding layer 203 contacts the metal layer 201. Therefore, the tin content increases as it extends from the lower surface of the bonding layer 203 toward the upper surface of the bonding layer 203. In addition, a copper content decreases as it extends from the lower surface of the bonding layer 203 toward the upper surface of the bonding layer 203.

Accordingly, pure tin may remain in a thickness range of 0.1 um to 0.3 um from the upper surface of the bonding layer 203.

The pad part may be easily bonded to terminals of a chip, a circuit board, and a display panel by the bonding layer 203. For example, when heat and pressure are applied to the pad part, an upper surface of the bonding layer melts. Pure tin remains on an upper surface of the bonding layer. Therefore, the pad part may be easily bonded to terminals of the chip, the circuit board, and the display panel.

Referring to FIG. 8, the metal layer 201 may include a first metal layer 201a and a second metal layer 201b. The first metal layer 201a is disposed on the buffer layer 205. The second metal layer 201b is disposed on the first metal layer 201a. The second metal layer 201b may be formed by electroplating using the first metal layer 201a as a seed layer. That is, the second metal layer 201b may be a plating layer.

A thickness of the first metal layer 201a may be smaller than a thickness of the second metal layer 201b.

For example, the thickness of the first metal layer 201a may be 0.7 um to 2 um, and the thickness of the second metal layer 201b may be 5 um to 25 um.

The first metal layer 201a and the second metal layer 201b may include a same metal material. For example, the first metal layer 201a and the second metal layer 201b may include copper (Cu).

The bonding layer 203 may include a first bonding layer 203a and a second bonding layer 203b.

The first bonding layer 203a is disposed on the metal layer 201. In detail, the first bonding layer 203a is disposed on the first wiring part 211, the first pad part 212a, and the second pad part 212b.

The second bonding layer 203b is disposed on the first bonding layer 203a. In detail, the second bonding layer 203b is disposed on the first pad part 212a and the second pad part 212b.

Therefore, the first wiring part 211 includes a buffer layer 205, a metal layer 201, and a first bonding layer 203a. In addition, the first pad part 212a and the second pad part 212b include a buffer layer 205, a metal layer 201, a first bonding layer 203a, and a second bonding layer 203b.

Therefore, a layer structure of the first wiring part 211 is different from layer structures of the first pad part 212a and the second pad part 212b.

The first bonding layer 203a and the second bonding layer 203b include metal. In detail, the first bonding layer 203a and the second bonding layer 203b may include tin (Sn).

The first bonding layer 203a and the second bonding layer 203b are disposed with different thicknesses. In detail, a thickness of the second bonding layer 203b is greater than a thickness of the first bonding layer 203a.

For example, the first bonding layer 203a has a thickness of 0.02 um to 0.06 um. In addition, the second bonding layer 203b has a thickness of 0.2 um to 0.6 um.

Therefore, the thickness of the first wiring part 211 becomes thin. The flexible circuit board includes a bending region BA that bends in one region. The wiring part is disposed on the bending region BA. Therefore, a thickness of the bonding layer on the wiring part is formed small. Accordingly, when the flexible circuit board is bent, cracks can be prevented from occurring in the first wiring part 211.

A thickness of the circuit pattern may be greater than 5 um to 25 um. In detail, the thickness of the circuit pattern may be 6 um to 20 um. In detail, the thickness of the circuit pattern may be 7 um to 15 um.

If the thickness of the circuit pattern is less than 5 um, a resistance of the circuit pattern may increase. If the thickness of the circuit pattern exceeds 25 um, it becomes difficult to implement a fine pattern.

Hereinafter, a flexible circuit board according to a second embodiment will be described with reference to FIGS. 9 to 13. Descriptions identical or similar to those of the first embodiment described above will be omitted.

The first direction 1D is the direction in which the fourth pad part 222b and the sixth pad part 232b face each other. The second direction 2D is a direction perpendicular to the first direction 1D. The third direction is a direction between the first direction 1D and the second direction 2D.

The flexible circuit board according to the second embodiment includes a substrate 100, a circuit pattern, and a protective layer.

The circuit pattern includes a first circuit pattern 210, a second circuit pattern 220, and a third circuit pattern 230.

The first circuit pattern 210 is disposed on the first surface 1S. The second circuit pattern 220 is disposed on the first surface 1S and the second surface 2S. The third circuit pattern 230 is disposed on the first surface 1S and the second surface 2S.

The first circuit pattern 210 is the same as the first circuit pattern of the first embodiment.

The second circuit pattern 220 is disposed on the first surface 1S and the second surface 2S. The second circuit pattern 220 includes a second wiring part 221a and 221b, a third pad part 222a, a fourth pad part 222b, and a first via V1. The second wiring part 221a and 221b, the third pad part 222a, and the fourth pad part 222b may include a same material. In addition, the second wiring part 221a and 221b, the third pad part 222a, and the fourth pad part 222b can be formed integrally.

A first protective layer 310 and a second protective layer 320 are respectively disposed on the second wiring part 221a and 221b. The first protective layer 310 and the second protective layer 320 are not disposed on the third pad part 222a and the fourth pad part 222b.

The third pad part 222a is disposed on the first surface 1S. The third pad part 222a is disposed inside the chip mounting region CHA. Accordingly, the third pad part 222a is connected to the terminal of the chip. As a result, the second circuit pattern 220 and the chip are connected.

The fourth pad part 222b is disposed on the second surface 2S. The fourth pad part 222b is connected to a terminal of an external display panel. Accordingly, the second circuit pattern 220 and the display panel are connected.

The second wiring part includes a second-first wiring part 221a and a second-second wiring part 221b. The second-first wiring part 221a is disposed on the first surface 1S. The second-second wiring part 221b is disposed on the second surface 2S. The second wiring parts 221a and 221b connect the third pad part 222a and the fourth pad part 222b. In detail, the second-first wiring part 221a is connected to the third pad part 222a. The second-second wiring part 221b is connected to the fourth pad part 222b.

Accordingly, the chip and the display panel are connected. Accordingly, a signal generated from the chip is transmitted to the display panel.

A first protective layer 310 and a second protective layer 320 are disposed on the second circuit pattern 220. In detail, the first protective layer 310 is disposed on the second circuit pattern 220 disposed on the first surface 1S. The second protective layer 320 is disposed on the second circuit pattern 220 disposed on the second surface 2S. The first protective layer 310 and the second protective layer 320 are not disposed on the third pad part 222a and the fourth pad part 222b.

The second-first wiring part 221a and the second-second wiring part 221b are connected. The second-first wiring part 221a and the second-second wiring part 221b are connected through the first via V1. The first via V1 penetrates the first surface 1S and the second surface 2S. Accordingly, the first via V1 is disposed on the first surface 1S and the second surface 2S. The first via V1 disposed on the first surface 1S and the first via V1 disposed on the second surface 2S are disposed at positions corresponding to each other.

The first via V1 includes a first via land VL1 and a first via hole VH1. The first via hole VH1 is formed inside the first via land VL1. The first via land VL1 includes a same material as the second wiring part 221a and 221b. A conductive material is disposed in the first via hole VH1. Accordingly, the second-first wiring part 221a and the second-second wiring part 221b are electrically connected.

The third circuit pattern 230 is disposed on the first surface 1S and the second surface 2S. The third circuit pattern 230 includes a third wiring part 231, a fifth pad part 232a, a sixth pad part 232b, and a second via V2. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a is disposed on the first surface 1S. The fifth pad part 232a is disposed inside the chip mounting region CHA. Accordingly, the fifth pad part 232a is connected to the terminal of the chip. As a result, the third circuit pattern 230 and the chip are connected.

The sixth pad part 232b is disposed on the second surface 2S. The sixth pad part 232b is connected to the terminal of the display panel. Accordingly, the third circuit pattern 230 and the display panel are connected.

The third wiring part 231 is disposed on the second surface 2S. The third wiring part 231 connects the fifth pad part 232a and the sixth pad part 232b. Accordingly, the chip and the display panel are connected. Accordingly, a signal generated from the chip is transmitted to the display panel.

A second protective layer 320 is disposed on the third circuit pattern 230. The second protective layer 320 is disposed on the third circuit pattern 230 disposed on the second surface 2S. The second protective layer 320 is not disposed on the sixth pad part 232b.

The fifth pad part 232a and the third wiring part 231 are connected. In detail, the fifth pad part 232a and the third wiring part 231 are connected through the second via V2. The second via V2 penetrates the first surface 1S and the second surface 2S. Accordingly, the second via V2 is disposed on the first surface 1S and the second surface 2S. The second via V2 disposed on the first surface 1S and the second via V2 disposed on the second surface 2S are disposed at positions corresponding to each other.

The second via V2 includes a second via land VL2 and a second via hole VH2. The second via land VL2 includes a same material as the third wiring part 231. The second via hole VH2 is formed inside the second via land VL2. A conductive material is disposed in the second via hole VH2. Accordingly, the fifth pad part 232a and the third wiring part 231 are electrically connected.

At least one pad part among the fourth pad part 222b and the sixth pad part 232b extends in a plurality of directions. In detail, the fourth pad part 222b and the sixth pad part 232b can extend in a different direction from the second wiring part 221 and the third wiring part 231. The fourth pad part 222b and the sixth pad part 232b extend in a different direction from the third pad part 222a and the fifth pad part 232a. The fourth pad part 222b and the sixth pad part 232b extend in a different direction from at least one pad part among the first pad part 212a and the second pad part 212b.

The fourth pad part 222b and the sixth pad part 232b may extend in the third direction. Alternatively, the fourth pad part 222b and the sixth pad part 232b may extend in the first direction 1D and the third direction.

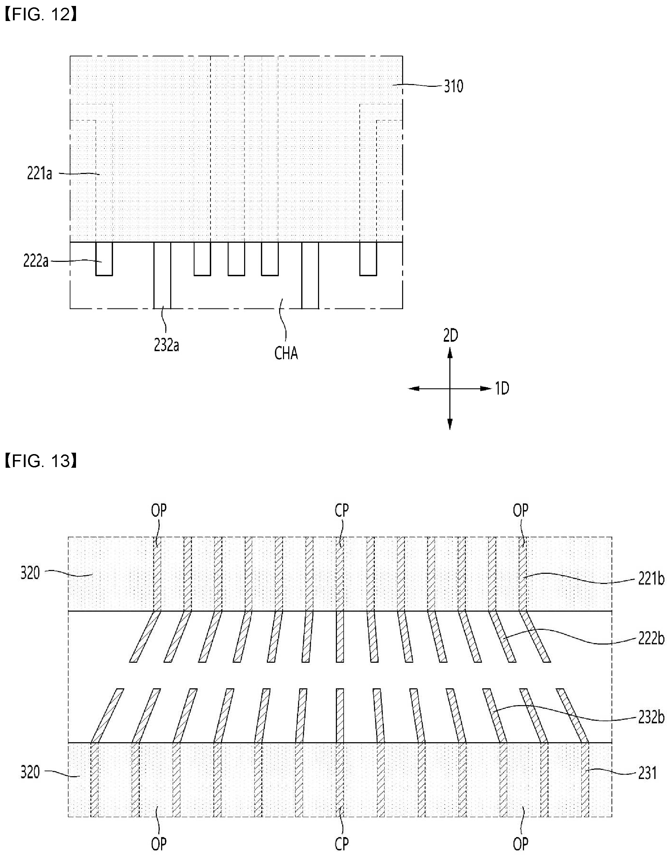

Referring to FIG. 13, the fourth pad part 222b and the sixth pad part 232b may extend in the first direction 1D and the third direction.

The fourth pad part 222b and the sixth pad part 232b may include one central pad part CP and a plurality of outer pad parts OP. The outer pad part OP is disposed in left and right directions of the central pad part CP.

The central pad part CP extends in the first direction 1D. The outer pad part OP extends in the third direction. The outer pad part OP may be disposed symmetrically left and right by the central pad part CP.

The outer pad part OP is inclined. That is, the outer pad part OP is disposed obliquely. For example, the outer pad part OP may be inclined in a direction in which the width increases or decreases. In detail, the outer pad part OP may be inclined in a direction in which a distance between outermost pad parts increases or decreases.

Inclination angles of the outer pad parts OP may vary as they extend in the second direction 2D. The inclination angle of the outer pad part OP is an angle formed by the central pad part CP and the outer pad part OP. In detail, the inclination angles of the outer pad parts OP may increase as they extend in the second direction 2D.

The second wiring part and the third wiring part extend in a plurality of directions.

The inclination angles of the outer pad parts OP may be different from the inclination angles of the second wiring part and the inclination angles of the third wiring part. In detail, a maximum inclination angle of the outer pad parts OP may be smaller than at least one of a maximum inclination angle of the second wiring part and a maximum inclination angle of the third wiring part.

Since the outer pad parts OP are disposed obliquely, the outer pad parts OP can be easily connected to terminals of various display panels.

That is, even when the line width of the terminal DP is larger than the line width of the fourth pad part 222b and the sixth pad part 232b, as described above, both the fourth pad part 222b and the sixth pad part 232b are connected to the terminal DP.

In addition, even when the line width of the terminal DP is smaller than the line width of the fourth pad part 222b and the sixth pad part 232b, both the fourth pad part 222b and the sixth pad part 232b are connected to the terminal DP.

Therefore, the fourth pad part and the sixth pad part can be connected to display panels having various sizes. In addition, the fourth pad part and the sixth pad part can be connected to display panels having various terminal sizes.

Therefore, it is not necessary to use a different flexible circuit board depending on a size of the display panel. Accordingly, the flexible circuit board can be applied to display panels for various purposes.

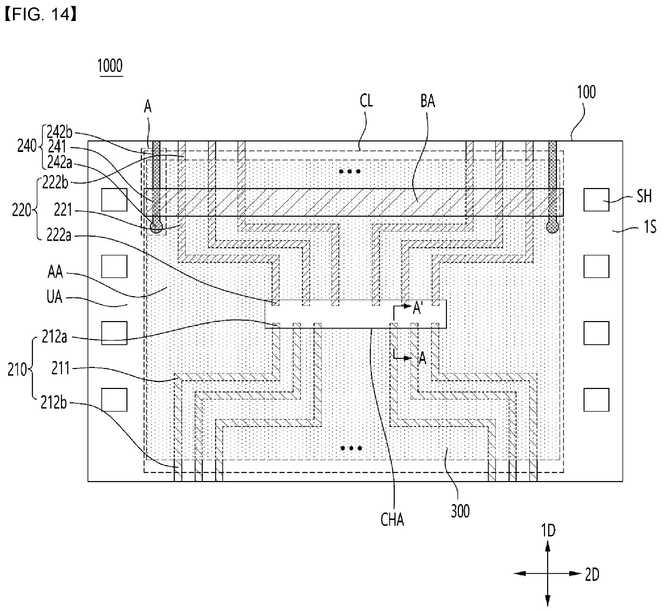

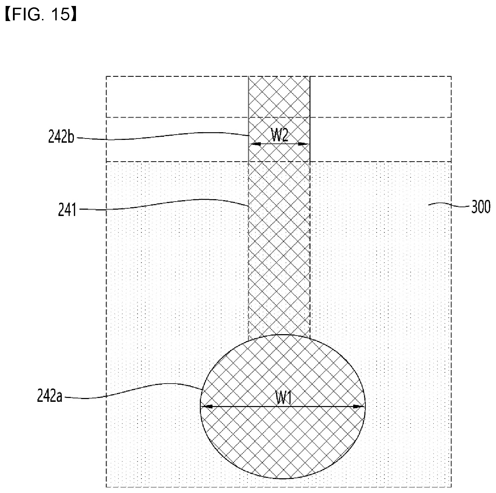

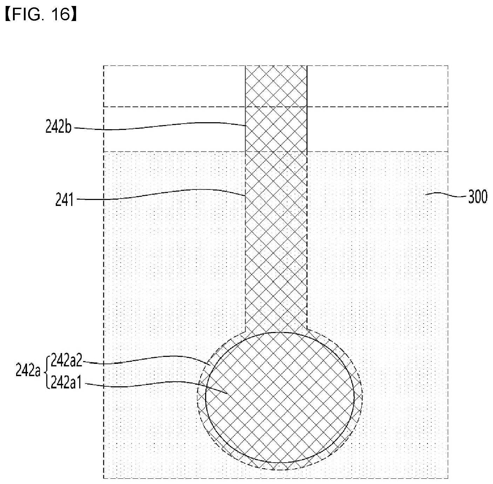

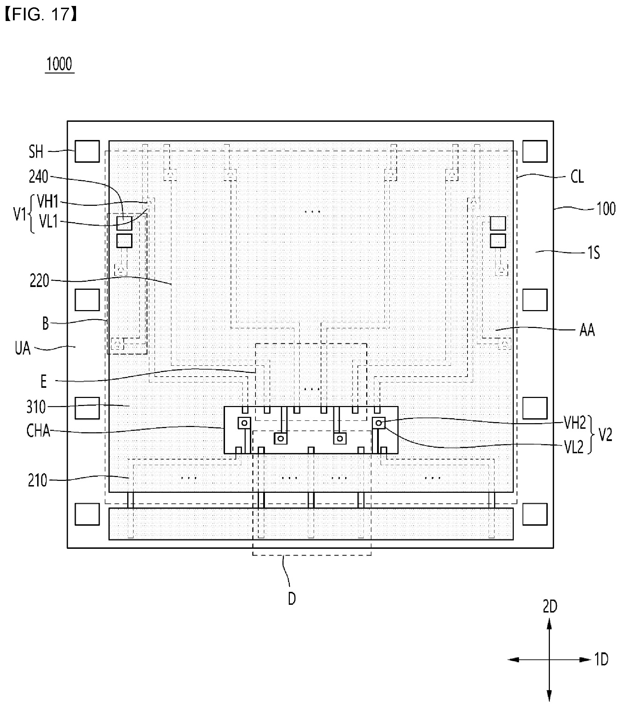

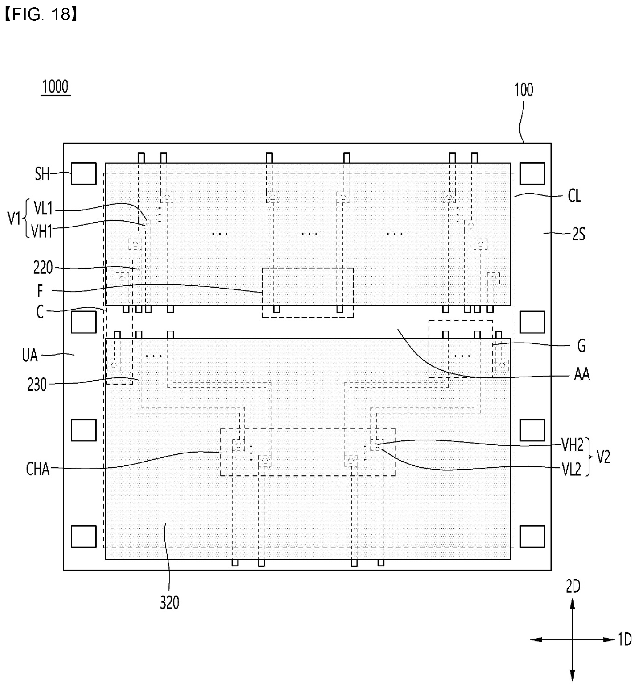

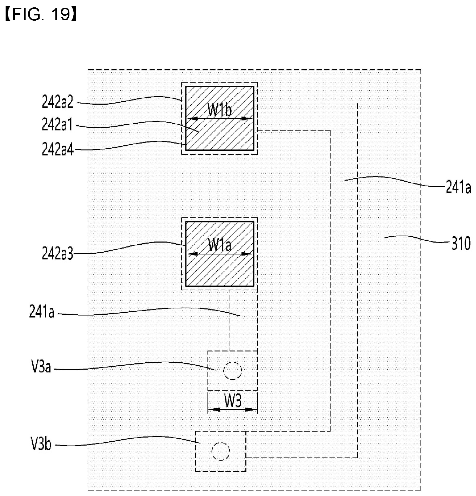

FIG. 14 is a top view of a flexible circuit board according to a third embodiment, FIG. 15 and FIG. 16 are enlarged views of a region A of FIG. 14, FIG. 17 is a top view of a flexible circuit board according to a fourth embodiment, FIG. 18 is a bottom view of a flexible circuit board according to a fourth embodiment, and FIG. 19 is an enlarged view of a region B of FIG. 17.

Hereinafter, a description will be made based on a structure different from the structure of the flexible circuit board of the first and second embodiments described with reference to FIGS. 1 to 13. At this time, in the flexible circuit boards of the third and fourth embodiments, components that are substantially the same as those of the first and second flexible circuit boards are described by giving them the same symbols.

Hereinafter, the third and fourth embodiments will be described based on a structure in which the outer pad part is disposed in a straight line rather than an oblique line. However, the embodiment is not limited thereto, and the outer pad part provided in the flexible circuit board of the third and fourth embodiments described below may be provided with a diagonal structure and a certain inclination angle as shown in FIGS. 1 to 13.

Referring to FIG. 14, the flexible circuit board of the third embodiment further includes a test pattern 240.

The test pattern 240 is disposed on the first surface 1S. The test pattern 240 is disposed on the effective region AA. The test pattern 240 is disposed adjacent to the second circuit pattern 220. The test pattern 240 is disposed adjacent to an edge of the substrate 100. For example, the test pattern 240 may be a pattern disposed on an outermost side of the substrate 100.

The test pattern 240 includes a seventh pad part 242a, an eighth pad part 242b, and a fourth wiring part 241.

The seventh pad part 242a is disposed outside the chip mounting region CHA. The seventh pad part 242a is disposed adjacent to the second wiring part 221.

The eighth pad part 242b is disposed outside the chip mounting region CHA. The eighth pad part 242b is disposed adjacent to the fourth pad part 222b.

The fourth wiring part 241 connects the seventh pad part 242a and the eighth pad part 242b. The seventh pad part 242a, the eighth pad part 242b, and the fourth wiring part 241 may be formed integrally.

The eighth pad part 242b is connected to the terminal of the display panel. Accordingly, a size of the eighth pad part 242b may be the same as or similar to the fourth pad part 222b.

The seventh pad part 242a is in contact with an external test device. The test device measures the performance of the display panel. In detail, the display panel is connected to the eighth pad part 242b, and the performance of the display panel is tested through the seventh pad part 242a. That is, the test pattern may be a pattern for testing the performance of the display panel.

Referring to FIG. 15, the protective layer 300 is not disposed on the seventh pad part 242a. For example, after the test pattern 240 is disposed on the substrate 100, the protective layer 300 may be disposed on the test pattern 240. The protective layer 300 is not disposed on the eighth pad part 242b. The protective layer 300 is disposed on the seventh pad part 242a and the fourth wiring part 241.

Then, when the performance of the display panel is to be measured, the protective layer 300 disposed on the seventh pad part 242a is removed. Accordingly, the seventh pad part 242a is exposed to an outside of the protective layer 300.

Referring to FIG. 16, the protective layer 300 may be partially disposed on the seventh pad part 242a. In detail, during a process of removing the protective layer 300, some of the protective layer may remain on the seventh pad part 242a. Accordingly, the seventh pad part 242a may include a first region 242a1 and a second region 242a2. The protective layer 300 is not disposed on the first region 242a1. The protective layer 300 is disposed on the second region 242a2.

An area of the first region 242a1 may be larger than an area of the second region 242a2. For example, the area of the first region 242a1 may be 50% or more of the area of the seventh pad part 242a. In detail, the area of the first region 242a1 may be 50% to 99%, 70% to 99%, 80% to 99%, 85% to 95%, or 88% to 92% of the area of the seventh pad part 242a.

If the area of the first region 242a1 is less than 50% of the area of the seventh pad part 242a, a contact area between the test device and the seventh pad part 242b may decrease. Accordingly, a measurement error of the test device may occur. If the area of the first region 242a1 exceeds 99% of the area of the seventh pad part 242a, the protective layer 300 outside the seventh pad part 242a may be removed due to a process error. Accordingly, another circuit pattern or a dummy pattern may be exposed to the outside of the protective layer. Accordingly, the circuit pattern or the dummy pattern may be corroded. Accordingly, the reliability of the flexible circuit board may be reduced.

The sizes of the seventh pad part 242a and the eighth pad part 242b are different.

Since the eighth pad part 242b is connected to the display panel, it may be similar to the size of the fourth pad part 222b. In detail, the line widths of the eighth pad part 242b and the fourth pad part 222b are the same or similar. Accordingly, when forming the circuit pattern and the test pattern, an etching uniformity may be improved.

The line width W1 of the seventh pad part 242a is different from the line width W2 of the eighth pad part 242b. In detail, the line width of the seventh pad part 242a is larger than the line width of the eighth pad part 242b. In addition, the line width of the seventh pad part 242a is larger than the maximum line width of the fourth wiring part.

The seventh pad part 242a requires a process of removing the protective layer 300. If the size of the seventh pad part 242a is small, the protective layer 300 must be removed finely. Accordingly, the process efficiency is reduced, and the protective layer disposed outside the seventh pad part 242a may be removed.

In addition, if the size of the seventh pad part 242a is small, a contact area between the test device and the seventh pad part 242a is reduced. Accordingly, a measurement error of the test device may occur. This makes it difficult to measure the performance of the display panel.

In addition, a line width of the seventh pad part 242a may be larger than a spacing of at least one of the first pad part 212a, the second pad part 212b, the third pad part 222a, and the fourth pad part 222b. In detail, a line width of the seventh pad part 242a may be larger than a spacing of each of the first pad part 212a, the second pad part 212b, the third pad part 222a, and the fourth pad part 222b.

In addition, a line width of the seventh pad part 242a may be larger than a line width of at least one of the first pad part 212a, the second pad part 212b, the third pad part 222a, and the fourth pad part 222b. In detail, a line width of the seventh pad part 242a may be larger than a line width of each of the first pad part 212a, the second pad part 212b, the third pad part 222a, and the fourth pad part 222b.

Shapes of the seventh pad part 242a and the eighth pad part 242b may be the same or different.

Referring to FIGS. 15 and 16, the seventh pad part 242a has a circular shape, and the eighth pad part 242b has a rectangular shape. However, the embodiment is not limited thereto. The shapes of the seventh pad part 242a and the eighth pad part 242b may be the same.

In addition, the seventh pad part 242a may be formed in various shapes other than a circular shape. Accordingly, depending on a method of removing the protective layer 300, the shape of the seventh pad part 242a can be varied. Accordingly, the protective layer disposed on the seventh pad part 242a can be easily removed.

In FIGS. 14 to 16, two test patterns 240 facing each other in the second direction 2D are illustrated. However, the embodiment is not limited thereto. The test pattern 240 may include one test pattern 240. Alternatively, the test pattern 240 may include three or more test patterns 240.

A line width of the fourth wiring part 241 may be the same as or similar to a line width of at least one of the first wiring part 211 and the second wiring part 221. Accordingly, when forming the circuit pattern and the test pattern, the etching uniformity can be improved.

Meanwhile, referring to FIGS. 17 to 19, a flexible circuit board according to the fourth embodiment includes a substrate 100, a circuit pattern, a test pattern, and a protective layer. A test pattern 240 is disposed on a first surface 1S and a second surface 2S of the substrate 100. The test pattern 240 is disposed on an effective region AA. The test pattern 240 is disposed adjacent to a second circuit pattern 220 and a third circuit pattern 230. The test pattern 240 is disposed adjacent to an edge of the substrate 100. The test pattern 240 is disposed closer to the edge of the substrate than the second and third circuit patterns. For example, the test pattern 240 may be a pattern disposed at an outermost side of the substrate 100.

The test pattern 240 includes a plurality of seventh pad parts 242a3 and 242a4, a plurality of eighth pad parts 242b1 and 242b2, a plurality of fourth wiring parts 241a and 241b, and a plurality of third vias V3a and V3b.

For example, the seventh pad part includes a seventh-first pad part 242a3 and a seventh-second pad part 242a4. The seventh-first pad part 242a3 and the seventh-second pad part 242a4 are spaced apart in a first direction 1D or a second direction 2D.

The seventh-first pad part 242a3 and the seventh-second pad part 242a4 may include a first region 242a1 and a second region 242a2, respectively. The first protective layer 310 is not disposed on the first region 242a1. The first protective layer 310 is disposed on the second region 242a2.

The fourth wiring part includes the fourth-first wiring part 241a and the fourth-second wiring part 241b. The fourth-first wiring part 241a is disposed on the first surface 1S. The fourth-second wiring part 241b is disposed on the second surface 2S.

The eighth pad part includes the eighth-first pad part 242b1 and the eighth-second pad part 242b2. The eighth-first pad part 242b1 and the eighth-second pad part 242b2 are spaced apart in the first direction 1D or the second direction 2D.

The eighth-first pad part 242b1 is disposed adjacent to the fourth pad part 222b. The eighth-second pad part 242b2 is disposed adjacent to the sixth pad part 232b.

The third via includes the third-first via V3a and the third-second via V3b. The third-first via V3a and the third-second via V3b are spaced apart in the first direction 1D or the second direction 2D. The fourth-first wiring part 241a and the fourth-second wiring part 241b are connected via the third-first via V3a and the third-second via V3b.

The seventh-first pad part 242a3 and the eighth-first pad part 242b1 are connected. In detail, the seventh-first pad part 242a3 and the eighth-first pad part 242b1 are connected through the fourth-first wiring part 241a, the fourth-second wiring part 241b, and the third-first via V3a.

The seventh-second pad part 242a4 and the eighth-second pad part 242b2 are connected. In detail, the seventh-second pad part 242a4 and the eighth-second pad part 242b2 are connected through the fourth-first wiring part 241a, the fourth-second wiring part 241b, and the third-second via V3b.

The eighth-first pad part 242b1 and the eighth-second pad part 242b2 are connected to terminals of the display panel. Accordingly, the size of the eighth-first pad part 242b1 may be the same as or similar to the fourth pad part 222b. In addition, the size of the eighth-second pad part 242b2 may be the same as or similar to the sixth pad part 232b.

The seventh-first pad part 242a3 and the seventh-second pad part 242a4 are in contact with an external test device. The test device measures the performance of the display panel. In detail, the display panel is connected to the eighth-first pad part 242b1 and the eighth-second pad part 242b2, and the performance of the display panel is tested through the seventh-first pad part 242a3 and the seventh-second pad part 242a4. That is, the test pattern may be a pattern for testing the performance of the display panel.

Referring to FIG. 19, the sizes of the seventh-first pad part 242a3 and the seventh-second pad part 242a4 are different from those of the eighth-first pad part 242b1 and the eighth-second pad part 242b2.

The eighth-first pad part 242b1 and the eighth-second pad part 242b2 are connected to the display panel. Therefore, the line width of the eighth-first pad part 242b1 is the same as or similar to the line width of the fourth pad part 222b. In addition, the line width of the eighth-second pad part 242b2 is the same as or similar to the line width of the sixth pad part 232b. Accordingly, when forming a circuit pattern and a test pattern, etching uniformity can be improved.

The line widths W1a and W1b of the seventh-first pad part 242a3 and the seventh-second pad part 242a4 are different from the line widths of the eighth-first pad part 242b1 and the eighth-second pad part 242b2. In detail, the line widths W1a and W1b of the seventh-first pad part 242a3 and the seventh-second pad part 242a4 are larger than the line widths of the eighth-first pad part 242b1 and the eighth-second pad part 242b2.

The seventh pad part 242a3 and 242a4 requires a process of removing the first protective layer 310. If the size of the seventh pad part 242a3 and 242a4 is small, the first protective layer 310 must be removed finely. Accordingly, the process efficiency is reduced, and the first protective layer disposed outside the seventh pad part 242a3 and 242a4 may be removed.

In addition, if the size of the seventh pad part 242a3 and 242a4 is small, the contact area between the test device and the seventh pad part 242a3 and 242a4 is reduced. Accordingly, a measurement error of the test device may occur. As a result, it becomes difficult to measure the performance of the display panel.

In addition, the line width W1a and W1b of the seventh pad part 242a3 and 242a4 may be larger than a line width W3 of the third via. The first protective layer 310 and the second protective layer 320 are disposed on the third via C3a and V3b. The protective layers disposed on the third via C3a and V3b are not removed. Therefore, the size of the third via C3a and V3b is smaller than the size of the seventh pad part 242a3 and 242a4.

In addition, the line width W1a and W1b of the seventh pad part 242a3 and 242a4 may be larger than a spacing of at least one of the first pad part 212a, the second pad part 212b, the third pad part 222a, the fourth pad part 222b, the fifth pad part 232a, and the sixth pad part 232b. For example, the line width W1a and W1b of the seventh pad part 242a3 and 242a4 may be larger than a spacing of each of the first pad part 212a, the second pad part 212b, the third pad part 222a, the fourth pad part 222b, the fifth pad part 232a, and the sixth pad part 232b.

In addition, the line width W1a and W1b of the seventh pad part 242a3 and 242a4 may be larger than the line width of at least one of the first pad part 212a, the second pad part 212b, the third pad part 222a, and the fourth pad part 222b. In detail, the line width W1a and W1b of the seventh pad part 242a3 and 242a4 may be larger than the line widths of the first pad part 212a, the second pad part 212b, the third pad part 222a, and the fourth pad part 222b.

The shapes of the seventh pad part 242a3 and 242a4 and the eighth pad part 242b1 and 242b2 may be the same or different.

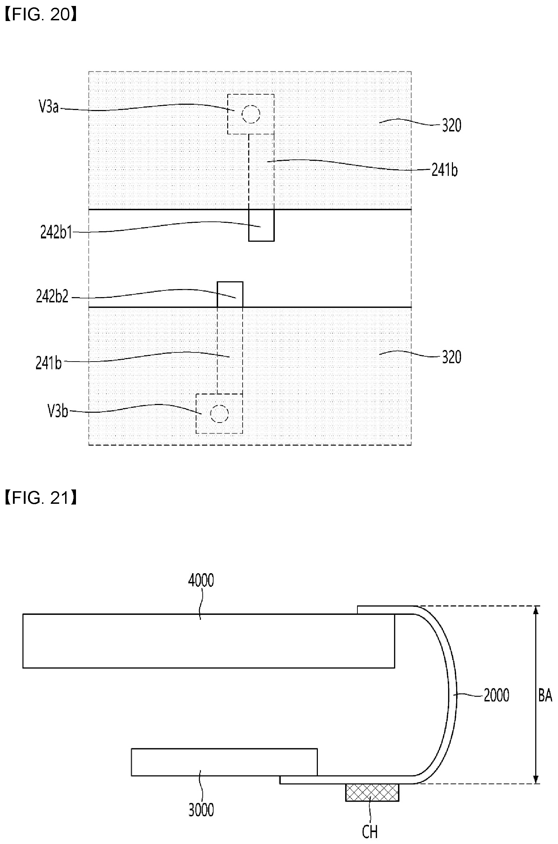

Referring to FIGS. 19 and 20, the seventh pad part 242a3 and 242a4 and the eighth pad part 242b1 and 242b2 have a rectangular shape. However, the embodiment is not limited thereto. The shapes of the seventh pad part 242a3 and 242a4 and the eighth pad part 242b1 and 242b2 may be different.

In FIGS. 17 to 20, two test patterns 240 facing each other in the second direction 2D are illustrated. However, the embodiment is not limited thereto. The test pattern 240 may include one test pattern 240. Alternatively, the test pattern 240 may include three or more test patterns 240.

The line width of the fourth wiring part 241 may be the same as or similar to the line width of at least one of the first wiring part 211, the second wiring part 221, and the third wiring part 231. Accordingly, when forming the circuit pattern and the test pattern, the etching uniformity may be improved.

In addition, the flexible circuit board according to the embodiment includes a test pattern.

The flexible circuit board is connected to the display panel and the circuit board. The test pattern can measure a performance of the display panel. Accordingly, the performance of the display panel can be confirmed before connecting the flexible circuit board and the display panel. Accordingly, it is possible to prevent a defect in the COF module due to a defect in the performance of the display panel after connecting the flexible circuit board, the display panel, and the circuit board.

The test pattern includes one pad part connected to the display panel and other pad part connected to the test device.

A line width of the other pad part is larger than a line width of the one pad part. The other pad part is formed by removing the protective layer. Since the line width of the other pad part is large, a process of removing the protective layer can be easily performed. Accordingly, process efficiency is improved. In addition, when removing the protective layer, it is possible to prevent other patterns from being exposed to an outside of the protective layer.

The test pattern is disposed on an outermost side of the substrate. Accordingly, interference of the test pattern can be prevented when connecting the flexible circuit board and the display panel.

Therefore, the reliability and electrical characteristics of the flexible circuit board and the COF module according to the embodiment are improved.

One end of the COF module 2000 is connected to the display panel 4000, and other end of the COF module 2000 is connected to the circuit board 3000.

Referring to FIG. 21, the display panel 4000 and the circuit board 3000 are disposed on one surface of the COF module 2000. That is, in the flexible circuit board according to the first embodiment, the display panel 4000 and the circuit board 3000 are disposed on a same surface of the COF module 2000.

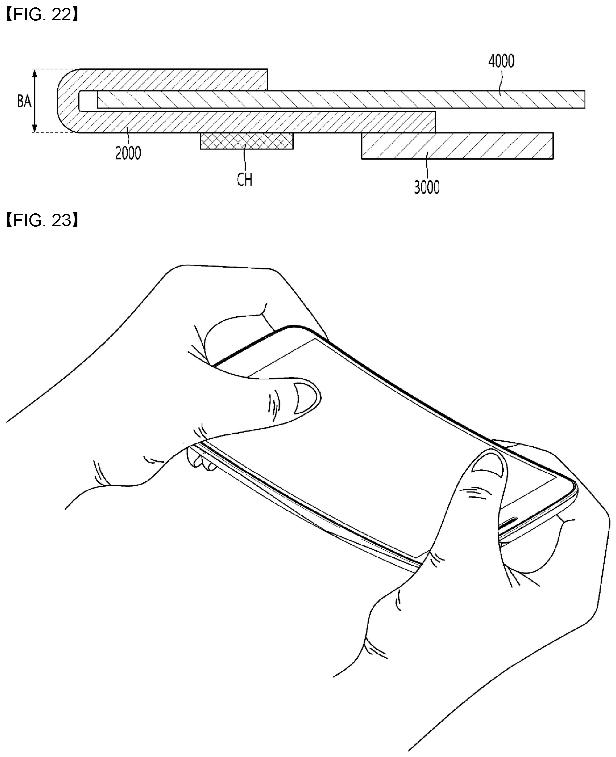

Referring to FIG. 22, the display panel 4000 and the circuit board 3000 are disposed on different surfaces of the COF module 2000. That is, in the flexible circuit board according to the second embodiment, the display panel 4000 and the circuit board 3000 are disposed on different surfaces of the COF module 2000.

Since the COF module 2000 includes a flexible substrate, it has a rigid shape and a bent shape between the display panel 3000 and the circuit board 4000. That is, the COF module 2000 may include a bending region BA.

The COF module 2000 connects the display panel 4000 and the circuit board 3000 that are disposed facing each other in a bent shape. Therefore, a thickness of the electronic device is reduced. In addition, the design freedom of the electronic device is improved. In addition, the COF module 2000 does not have wiring disconnected even in a bent shape. Accordingly, the reliability of the electronic device is improved.

Since the COF module is flexible, it can be used in various electronic devices.

For example, referring to FIG. 23, the COF module may be applied to a flexible touch window having a bending characteristic. Therefore, a touch device including the COF module can be a flexible touch device. Therefore, a user can bend or fold the flexible touch device by a hand. Such a flexible touch window can be applied to a wearable touch, etc.

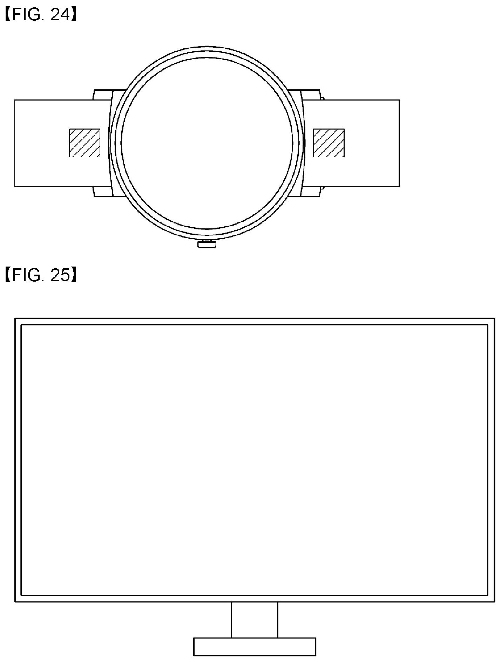

Referring to FIG. 24, the COF module can be applied to various wearable touch devices including a curved display. Therefore, an electronic device including the COF module can be slimmed down or made lightweight.

Referring to FIG. 25, the COF module can be used in various electronic devices having a display portion, such as a TV, a monitor, and a laptop. At this time, the COF module can also be used in an electronic device having a curved display portion.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate including a first surface and a second surface opposite to the first surface;
a circuit pattern disposed on the first surface; and
a protective layer disposed on the circuit pattern and including a plurality of open regions,
wherein the substrate includes a first side end and a second side end facing each other in a first direction,
wherein the open region includes a first open region provided between the first side end and the second side end, a second open region spaced from the first open region and closer to the first side end, and a third open region spaced from the first open region and closer to the second side end,
wherein the circuit pattern includes:
a first circuit pattern including a first pad part disposed in the first open region; a second pad part disposed in the second open region; and a first wiring part connecting between the first pad part and the second pad part; and
a second circuit pattern including a third pad part disposed in the first open region; a fourth pad part disposed in the third open region; and a second wiring part connecting between the third pad part and the fourth pad part, and
wherein a first direction in which the second pad part and the fourth pad part face each other, a second direction perpendicular to the first direction, and a third direction between the first direction and the second direction are defined, and
wherein at least one fourth pad part extends in the third direction on the substrate.

2. The flexible circuit board of claim 1, wherein the fourth pad part extends in the first direction and the third direction.

3. The flexible circuit board of claim 2, wherein the fourth pad part includes a central pad part and an outer pad part,
wherein the central pad part extends in the first direction, and
wherein the outer pad part extends in the third direction.

4. The flexible circuit board of claim 3, wherein an inclination angle of the outer pad part increases as it moves away from the central pad part.

5. The flexible circuit board of claim 3, wherein the second wiring part includes a second-first wiring part and a second-second wiring part,
wherein the second-first wiring part extends in the first direction,
wherein the second-second wiring part extends in the first direction and the third direction, and
wherein a maximum inclination angle of the outer pad part is smaller than a maximum inclination angle of the second-second wiring part.

6. The flexible circuit board of claim 3, wherein the outer pad part extends in a different direction from at least one pad part among the first pad part, the second pad part, and the third pad part.

7. The flexible circuit board of claim 1, wherein the circuit pattern further includes a third circuit pattern including a fifth pad part disposed in the second open region; a sixth pad part disposed in the third open region; and a third wiring part connecting between the fifth pad part and the sixth pad part.

8. The flexible circuit board of claim 7, wherein at least one sixth pad part extends in the third direction.

9. The flexible circuit board of claim 8, wherein the sixth pad part extends in the first direction and the third direction.

10. The flexible circuit board of claim 8, wherein the sixth pad part includes a central pad part and an outer pad part,
wherein the central pad part extends in the first direction, and
wherein the outer pad part extends in the third direction.
